# DEMANDE DE BREVET EUROPEEN

(11) **EP 2 246 886 A1**
(43) Date de publication de la demande: **03.11.2010**
(21) Numéro de dépôt: 10153640.7
(22) Date de dépôt: 15.02.2010
(51) Int. Cl.: H01L 27/02

(54) **Circuit intégré muni d'une protection de grande surface contre les décharges électrostatiques**

(30) Priorité: 27.04.2009 FR 0952753
(71) Demandeur: STmicroelectronics SA, 92120 Montrouge (FR)
(72) Inventeur: Galy, Philippe, 38660, LE TOUVET (FR); Entringer, Christophe, 38190, BRIGNOUD (FR)
(74) Mandataire: de Beaumont, Michel

(57) **Abrégé**

L'invention concerne un circuit intégré protégé contre des décharges électrostatiques comportant : des premier et second rails d'alimentation (5, 7) ; des premier et second rails intermédiaires (5', 7') normalement connectés aux premier et second rails d'alimentation ; des inverseurs constitués d'un transistor MOS à canal P (31) relié en série à un transistor MOS à canal N (33), les sources (45, 55) des transistors MOS à canal P et N étant respectivement reliées aux premier et second rails d'alimentation et les corps (49, 59) des transistors MOS à canal P et N étant respectivement reliés aux premier et second rails intermédiaires ; un détecteur de surtension positive entre les premier et second rails d'alimentation ; et un commutateur pour relier les premier et second rails intermédiaires (5', 7') aux second et premier rails d'alimentation (7, 5) lorsque une surtension positive est détectée.

## Description

### Domaine de l'invention

La présente invention concerne des moyens de protection des circuits intégrés contre des décharges électrostatiques.

### Exposé de l'art antérieur

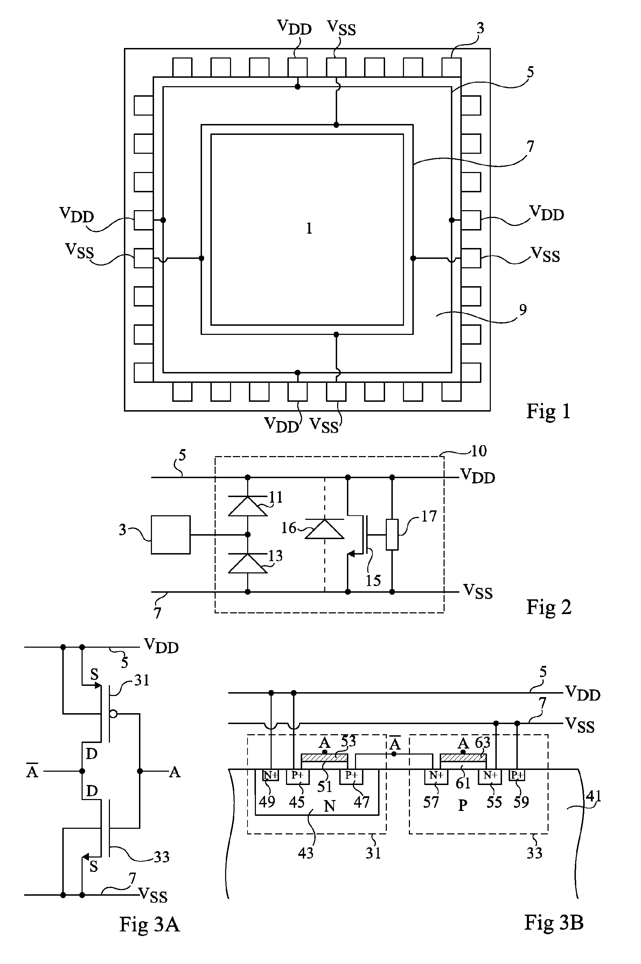

La figure 1 est une vue de dessus schématique d'une puce de circuit intégré. Le circuit intégré comprend une partie centrale 1 reliée à un ensemble de plots métalliques 3 disposés à la périphérie de la puce et destinés à assurer des connexions vers l'extérieur. La partie centrale 1 comprend l'ensemble des composants permettant au circuit intégré de remplir des fonctions souhaitées. Certains des plots 3 sont destinés à recevoir des potentiels d'alimentation haut (V_{DD}) et bas (V_{SS}). Des rails d'alimentation haute 5 et basse 7 sont généralement prévus tout autour du circuit. Les autres plots 3 sont notamment destinés à recevoir et/ou à fournir des signaux d'entrée-sortie. L'ensemble du circuit est recouvert d'une couche isolante ne laissant accessible que des bornes reliées aux plots 3, et est éventuellement mis dans un boîtier comprenant des cosses reliées aux plots 3 ou des billes liées à ces plots.

Un tel circuit reçoit et/ou fournit généralement des signaux à faible niveau de tension (par exemple 0,6 à 3 V) et à faible intensité de courant (par exemple 1 µA à 10 mA), et est susceptible d'être endommagé lorsque des surtensions ou des surintensités surviennent entre des plots du boîtier. Des surtensions peuvent survenir, pendant la phase de fabrication ou d'assemblage, avant le montage du circuit dans un dispositif (par exemple sur une carte de circuit imprimé), lors de décharges électrostatiques liées à la manipulation des circuits par des outils ou à la main. Ces surtensions peuvent atteindre plusieurs milliers de volts et détruire des éléments du circuit.

On prévoit donc d'associer à chaque plot 3 une structure de protection qui occupe généralement une couronne 9 disposée entre les plots 3 et la partie centrale 1 de la puce. La structure de protection doit être capable d'évacuer rapidement des courants importants, susceptibles d'apparaître lorsqu'une décharge électrostatique survient entre deux plots ou deux bornes du boîtier.

La figure 2 représente un exemple de structure de protection 10, associée à un plot d'entrée-sortie 3 d'un circuit intégré. Une diode 11 est connectée en direct entre le plot 3 et le rail d'alimentation haute 5. Une diode 13 est connectée en inverse entre le plot 3 et le rail d'alimentation basse 7. Un transistor MOS 15, utilisé comme interrupteur, est connecté entre les rails 5 et 7 d'alimentation haute et basse. Un circuit 17 de détection de surtension, connecté parallèlement au transistor MOS 15, fournit un signal de déclenchement à ce transistor. Le circuit 17 de détection de surtension pourra par exemple être un détecteur de front comprenant une résistance en série avec un condensateur, le noeud de connexion entre la résistance et le condensateur changeant d'état en cas de surtension brutale. Le transistor MOS 15 comporte notamment une diode parasite 16 connectée en direct entre le rail 7 et le rail 5.

On indiquera ci-après le fonctionnement de la structure de protection en cas de surtension survenant sur un plot d'entrée-sortie (on parlera simplement de "plots") ou sur un plot relié à un rail d'alimentation (on parlera simplement de "rail").

En fonctionnement normal, lorsque la puce est alimentée, les signaux sur les plots 3 et les rails 5 et 7 sont tels que les diodes 11 et 13 ne laissent pas passer de courant et le circuit de détection 17 rend le transistor MOS 15 non passant.

En cas de surtension positive entre les rails 5 et 7 d'alimentation haute et basse, le circuit 17 rend le transistor 15 passant, ce qui permet l'évacuation de la surtension.

En cas de surtension négative entre les rails 5 et 7 d'alimentation haute et basse, la diode parasite 16 devient passante et la surtension est évacuée.

En cas de surtension positive entre un plot 3 et le rail d'alimentation haute 5, la diode 11 devient passante et la surtension est évacuée.

En cas de surtension négative entre un plot 3 et le rail 5, le circuit 17 rend le transistor 15 passant, et la surtension est évacuée par le transistor 15 et la diode 13.

En cas de surtension positive entre un plot 3 et le rail d'alimentation basse 7, la diode 11 devient passante et la surtension positive est reportée sur le rail d'alimentation haute 5, ce qui correspond au cas traité ci-dessus d'une surtension positive entre les rails 5 et 7.

En cas de surtension négative entre un plot 3 et le rail d'alimentation basse 7, la diode 13 devient passante et la surtension est évacuée.

En cas de surtension positive ou négative entre deux plots 3, les diodes 11 ou 13 associées aux plots concernés deviennent passantes, et la surtension est reportée sur les rails d'alimentation haute 5 et basse 7. Cela correspond à l'un des cas de surtension traités ci-dessus.

Un inconvénient d'une telle structure de protection réside dans le fait que, pour pouvoir évacuer les courants induits par des décharges électrostatiques, les diodes 11 et 13 et le transistor 15 doivent avoir une surface importante (par exemple, un périmètre de jonction de 200 µm par diode et une longueur de grille de 1000 µm par transistor). Il en résulte que la couronne 9 (figure 1) occupe une surface de silicium importante, au détriment de la partie centrale 1 de la puce. En outre, du fait de sa grande taille, le transistor MOS 15 à l'état bloqué est traversé par des courants de fuite significatifs, ce qui augmente la consommation du circuit.

### Résumé

Un objet de la présente invention est de proposer un circuit intégré muni d'une protection contre des décharges électrostatiques, cette protection n'augmentant pas ou peu la surface de silicium occupée par le circuit.

Un objet d'un mode de réalisation de la présente invention est de proposer une telle protection ne perturbant pas le bon fonctionnement du circuit dans les conditions normales d'utilisation.

Un objet d'un mode de réalisation de la présente invention est de proposer une telle protection facile à réaliser.

De façon générale, un mode de réalisation de la présente invention prévoit d'utiliser, en cas de surtension, des inverseurs existant dans la partie centrale du circuit intégré comme chemin d'évacuation de la surtension.

Ainsi, un mode de réalisation de la présente invention prévoit un circuit intégré protégé contre des décharges électrostatiques comportant : des premier et second rails d'alimentation ; des premier et second rails intermédiaires normalement connectés aux premier et second rails d'alimentation ; des inverseurs constitués d'un transistor MOS à canal P relié en série à un transistor MOS à canal N, les sources des transistors MOS à canal P et N étant respectivement reliées aux premier et second rails d'alimentation et les corps des transistors MOS à canal P et N étant respectivement reliés aux premier et second rails intermédiaires ; un détecteur de surtension positive entre les premier et second rails d'alimentation ; et un commutateur pour relier les premier et second rails intermédiaires aux second et premier rails d'alimentation lorsque une surtension positive est détectée.

Selon un mode de réalisation de la présente invention, l'ensemble du détecteur de surtension positive et du commutateur comprend : une résistance et un condensateur ayant un noeud de connexion commun, reliés en série entre les rails d'alimentation ; un premier inverseur en série avec un second inverseur, l'entrée du premier inverseur étant connectée audit noeud de connexion, le premier rail intermédiaire étant connecté à la sortie du second inverseur et le second rail intermédiaire étant connecté à la sortie du premier inverseur ; une première diode connectée en direct entre le premier rail intermédiaire et le premier rail d'alimentation ; et une seconde diode connectée en inverse entre le second rail intermédiaire et le second rail d'alimentation.

Selon un mode de réalisation de la présente invention, les première et seconde diodes sont constituées des diodes parasites présentes dans les premier et second inverseurs.

Selon un mode de réalisation de la présente invention, 50 à 95% de la surface totale sont occupés par les inverseurs.

Un mode de réalisation de la présente invention prévoit un procédé de protection contre des surtensions d'un circuit intégré comportant des premier et second rails d'alimentation, des premier et second rails intermédiaires, et des inverseurs constitués d'un transistor MOS à canal P relié en série à un transistor MOS à canal N, les sources des transistors MOS à canal P et N étant respectivement reliées aux premier et second rails d'alimentation et les corps des transistors MOS à canal P et N étant respectivement reliés aux premier et second rails intermédiaires, ce procédé comportant les étapes suivantes : détecter des surtensions éventuelles entre les premier et second rails d'alimentation lorsque le circuit intégré n'est pas alimenté ; connecter le premier rail intermédiaire au premier rail d'alimentation et le second rail intermédiaire au second rail d'alimentation lorsque le circuit intégré est alimenté ou lorsque le circuit intégré n'est pas alimenté et qu'une surtension négative est détectée ; et connecter le premier rail intermédiaire au second rail d'alimentation et le second rail intermédiaire au premier rail d'alimentation lorsque le circuit n'est pas alimenté et qu'une surtension positive est détectée.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, précédemment décrite, est une vue de dessus schématique d'une puce de circuit intégré ;
la figure 2, précédemment décrite, représente un exemple de structure de protection contre les surtensions associée à un plot d'un circuit intégré ;
la figure 3A représente de façon schématique un circuit inverseur ;
la figure 3B représente une vue en coupe d'un exemple de réalisation d'un inverseur ;
la figure 4 représente une structure de protection contre des surtensions utilisant un inverseur du circuit intégré comme élément de protection ;
la figure 5 représente de façon plus détaillée le circuit de détection de surtension et de commutation de rails de la figure 4 ;
la figure 6A représente une portion d'un circuit intégré dans lequel les inverseurs sont utilisés comme éléments de protection contre des surtensions ; et
la figure 6B illustre de façon schématique le comportement du circuit de la figure 6A en cas de surtension.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

L'inverseur est un composant élémentaire des circuits intégrés logiques réalisés en technologie CMOS (Complementary Metal Oxide Semiconductor). De façon générale, la partie centrale 1 (figure 1) d'une puce de circuit intégré comporte notamment des inverseurs reliés aux rails 5 et 7 d'alimentation haute (V_{DD}) et basse (V_{SS}). Les inverseurs sont combinés entre eux pour remplir des fonctions souhaitées. Généralement, 50 à 95% de la surface de silicium de la partie centrale d'un circuit intégré est occupée par des inverseurs.
La figure 3A représente le schéma d'un inverseur. Les sources (S) d'un transistor MOS à canal P 31 et d'un transistor MOS à canal N 33 sont connectées respectivement aux rails 5 et 7 d'alimentation haute (V_{DD}) et basse (V_{SS}). Les drains (D) des transistors 31 et 33 sont interconnectés en un noeud de sortie A̅. Les corps des transistors 31 et 33 sont connectés à leurs sources, c'est-à-dire respectivement aux rails 5 et 7. Les grilles des transistors 31 et 33 sont interconnectées en un noeud d'entrée A. Lorsque le signal d'entrée A est à l'état haut, le transistor à canal P 31 est bloqué, le transistor à canal N 33 est passant, et le signal de sortie A̅ est au potentiel d'alimentation basse (état bas). Lorsque le signal d'entrée A est à l'état bas, le transistor 31 est passant, le transistor 33 est bloqué, et le signal de sortie A̅ est au potentiel d'alimentation haute (état haut).
La figure 3B est une vue en coupe d'un exemple de réalisation d'un inverseur. La structure est formée dans un substrat de silicium faiblement dopé de type P 41, le substrat pouvant être un substrat massif ou la couche supérieure d'une structure dite SOI. Un transistor MOS à canal P 31 est réalisé dans un caisson faiblement dopé de type N qui constitue le corps 43 du transistor 31. Deux régions fortement dopées de type P constituent la source 45 et le drain 47 du transistor. Une région de contact de corps 49, à fort niveau de dopage de type N, est formée à la surface du corps 43. Une couche d'isolant 51, recouvrant la surface comprise entre les régions 45 et 47, est recouverte d'une grille conductrice 53. Un transistor MOS à canal N 33, voisin du transistor 31, est formé dans le substrat 41. Deux régions fortement dopées de type N constituent la source 55 et le drain 57 du transistor 33. Une région de contact de corps 59 à fort niveau de dopage de type P est formée à la surface du substrat 41. Une couche d'isolant 61, recouvrant la surface comprise entre les régions 55 et 57, est recouverte d'une grille conductrice 63.

La source 45 et la région de contact de corps 49 du transistor 31 sont connectées au rail 5 d'alimentation haute (V_{DD}). La source 55 et la région de contact de corps 59 du transistor 33 sont connectées au rail 7 d'alimentation basse (V_{SS}). Les grilles 53 et 63 des transistors 31 et 33 reçoivent le signal d'entrée A de l'inverseur. Les drains 47 et 57 des transistors 31 et 33 sont connectés entre eux et fournissent le signal de sortie A̅ de l'inverseur.

De façon générale, on propose ici d'utiliser les inverseurs existants dans la partie centrale d'un circuit intégré logique comme chemin d'évacuation des décharges électrostatiques. Ces inverseurs occupant typiquement plus de 50% et jusqu'à 95% de la surface de silicium de la partie centrale d'un circuit, une importante surface de silicium sera alors disponible pour dissiper les décharges électrostatiques. Un mode de réalisation de l'invention prévoit, en cas de surtension, un mode de connexion particulier des inverseurs aux rails d'alimentation, permettant l'évacuation de la surtension.

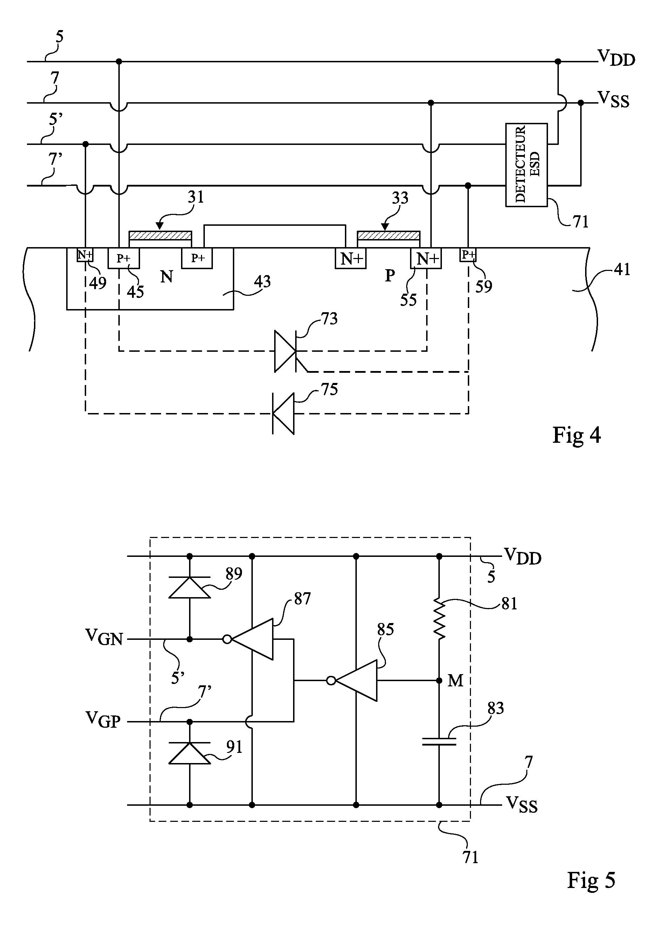

La figure 4 illustre l'utilisation d'un inverseur comme élément de protection contre des surtensions. De façon classique, la source 45 du transistor MOS à canal P 31 est reliée au rail 5 d'alimentation haute (V_{DD}) et la source 55 du transistor MOS à canal N 33 est reliée au rail 7 d'alimentation basse (V_{SS}). Des rails intermédiaires 5' et 7' sont de plus prévus. La région de contact de corps 49 du transistor 31 est connectée au rail intermédiaire 5', au lieu d'être connectée au rail d'alimentation 5 pour un inverseur classique, et la région de contact de corps 59 du transistor 33 est connectée au rail intermédiaire 7' au lieu d'être connectée au rail d'alimentation 7.

Un circuit de détection et de commutation 71, connecté aux rails d'alimentation 5 et 7 d'une part et aux rails intermédiaires 5' et 7' d'autre part, est prévu pour :
- détecter une éventuelle surtension entre les rails 5 et 7 lorsque le circuit intégré n'est pas alimenté,
- connecter le rail 5' au rail 5 et le rail 7' au rail 7 lorsque le circuit intégré est alimenté, ou lorsque le circuit n'est pas alimenté et qu'une surtension négative est détectée, et
- connecter le rail 5' au rail 7 et le rail 7' au rail 5 lorsque le circuit n'est pas alimenté et qu'une surtension positive est détectée.

Ainsi, en fonctionnement normal, lorsque le circuit intégré est alimenté, les régions de contact de corps 49 et 59 des transistors 31 et 33 sont connectées aux rails 5 et 7. Le fonctionnement de l'inverseur n'est donc pas perturbé.

On notera que les transistors 31 et 33 définissent, entre leurs sources 45 et 55 respectives, un thyristor parasite PNPN 73, correspondant aux régions 45-43-41-55. Le thyristor 73 a une gâchette de cathode qui correspond à la région de contact de corps 59, de type P. Les transistors 33 et 31 définissent en outre, entre leurs régions de contact de corps respectives 59 (de type P) et 49 (de type N), une diode 75.

En cas de surtension positive entre les rails 5 et 7 lorsque le circuit intégré n'est pas alimenté, le rail 5' est connecté au rail 7 et le rail 7' est connecté au rail 5. Ainsi, l'anode 45 du thyristor 73 est reliée au rail positif 5 et la cathode 55 du thyristor 73 est reliée au rail négatif 7. Le thyristor 73 est donc polarisé dans un sens propre à être passant et il est rendu passant du fait que sa gâchette de cathode 59 est reliée au rail 7' qui est alors positif. La surtension est donc évacuée par le thyristor.

En cas de surtension négative entre les rails 5 et 7, le rail 5' est connecté au rail 5 et le rail 7' est connecté au rail 7. Ainsi, l'anode 59 de la diode 75 reçoit sensiblement le potentiel, en ce cas positif, du rail 7 et la cathode 49 de la diode 75 reçoit sensiblement le potentiel, en ce cas négatif, du rail 5. La diode 75 est donc rendue passante et évacue la surtension.

La figure 5 représente de façon détaillée un mode de réalisation possible d'un circuit de détection de décharge électrostatique et de commutation. Un détecteur de fronts, constitué d'une résistance 81 en série avec une capacité 83, est connecté entre les rails d'alimentation 5 et 7. Le noeud M entre la résistance 81 et la capacité 83 est relié à l'entrée d'un inverseur 85. La sortie de l'inverseur 85 est reliée à l'entrée d'un inverseur 87 et au rail intermédiaire 7'. La sortie de l'inverseur 87 est reliée au rail intermédiaire 5'. Les inverseurs 85 et 87 sont alimentés par les rails d'alimentation 5 et 7. Une diode 89 est connectée en direct entre la sortie de l'inverseur 87 et le rail 5. Une diode 91 est connectée en inverse entre la sortie de l'inverseur 85 et le rail 7.

En fonctionnement normal, lorsque le circuit est alimenté, le noeud M est à un état haut. Le rail 5' est donc à un état haut, c'est-à-dire sensiblement au potentiel V_{DD} du rail 5 d'alimentation haute. Le rail 7' est à un état bas, c'est-à-dire sensiblement au potentiel V_{SS} du rail 7 d'alimentation basse.

Lorsque le circuit intégré n'est pas alimenté, le noeud M est à un état bas. Les inverseurs 85 et 87 n'étant pas alimentés, les rails 5' et 7' sont à un état indéterminé.

Si une surtension positive survient entre les rails 5 et 7, le noeud M reste à un état bas. La surtension fournit une alimentation aux inverseurs 85 et 87. Le rail 5' est donc amené à un état bas, c'est-à-dire sensiblement au même potentiel négatif que le rail 7. Le rail 7' est amené à un état haut, c'est-à-dire sensiblement au même potentiel positif que le rail 5. Ainsi, la surtension est évacuée par le thyristor 73 de la façon décrite en relation avec la figure 4.

Si une surtension négative survient entre les rails 5 et 7, le noeud M reste à un état bas. Les diodes 89 et 91 sont rendues passantes. Le rail 5' est donc amené sensiblement au même potentiel (négatif dans ce cas) que le rail 5 et le rail 7' est amené sensiblement au même potentiel (positif dans ce cas) que le rail 7. Ainsi, la surtension est évacuée par la diode 75 de la façon décrite en relation avec la figure 4.

Pour une meilleure compréhension, le circuit de détection et de commutation décrit ci-dessus comporte deux diodes 89 et 91. On notera que les fonctions de ces diodes peuvent être remplies par les diodes parasites des transistors MOS constituant les inverseurs 85 et 87.

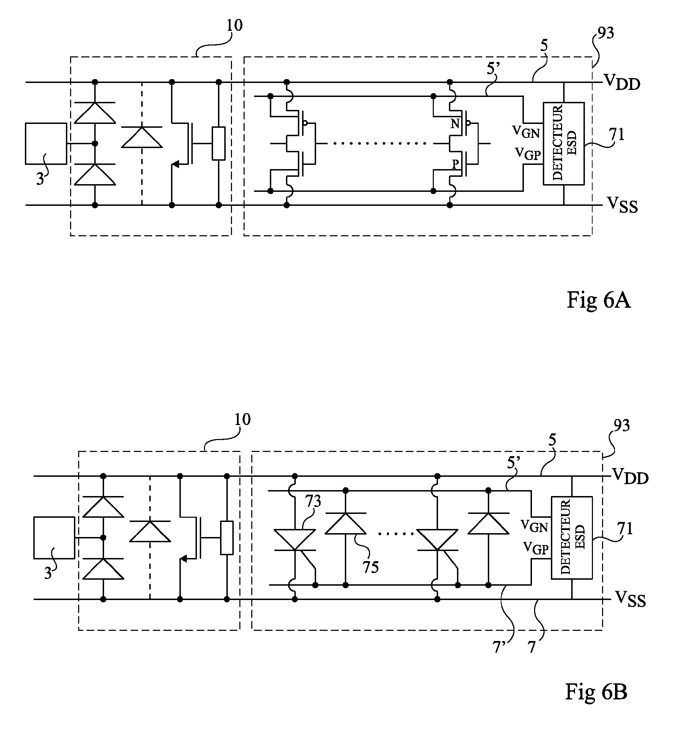

La figure 6A représente de façon schématique une portion d'un circuit intégré dans lequel des inverseurs sont utilisés comme éléments de protection contre des surtensions. Une structure de protection traditionnelle 10, associée à un plot d'entrée-sortie 3, est comprise entre la ligne de plots et la partie centrale 1 (figure 1). Une portion 93 de la partie centrale 1 comprend notamment des inverseurs connectés entre les rails 5 et 7 d'alimentation haute (V_{DD}) et basse (V_{SS}). Les régions de corps de type N des inverseurs sont reliées à un rail intermédiaire 5' et les régions de corps de type P sont reliées à un rail intermédiaire 7'. Un circuit 71 de détection de décharge électrostatique et de commutation, tel que décrit ci-dessus en relation avec la figure 5, est connecté aux rails d'alimentation 5 et 7 d'une part et aux rails intermédiaires 5' et 7' d'autre part. Lorsque le circuit intégré est alimenté, les rails intermédiaires 5' et 7' sont respectivement reliés aux rails d'alimentation 5 et 7, de façon que les inverseurs se comportent normalement.

La figure 6B représente de façon schématique le comportement, en cas de surtension, de la portion de circuit intégré décrite à la figure 6A.

Si la surtension entre les rails 5 et 7 est positive, les rails intermédiaires 5' et 7' sont respectivement connectés aux rails 7 et 5 (par le circuit 71). Ainsi, les thyristors 73 et diodes 75, intrinsèques aux inverseurs sont rendus passants et la surtension est évacuée.

Si la surtension est négative, les rails intermédiaires 5' et 7' sont respectivement connectés aux rails 5 et 7 (par le circuit 71). Ainsi, les diodes 75, intrinsèques aux inverseurs sont rendues passantes et la surtension est évacuée.

Selon un avantage de l'invention, des inverseurs existants du circuit intégré sont utilisés comme éléments de protection contre des décharges électrostatiques.

Selon un avantage de l'invention, les inverseurs occupent généralement la majorité de la surface de silicium d'un circuit intégré, et une surface de silicium importante est donc disponible pour évacuer des surtensions.

Selon un avantage de l'invention, les éléments nécessaires à l'utilisation des inverseurs du circuit intégré comme éléments de protection contre des surtensions comprennent seulement les rails 5' et 7' et le détecteur 71 et occupent une surface négligeable.

Des modes de réalisation particuliers de la présente invention ont été décrits. Diverses variantes et modifications apparaîtront à l'homme de l'art. En particulier, l'invention ne se retreint pas au seul circuit de détection de surtension et de commutation décrit ci-dessus en relation avec la figure 5. L'homme de l'art saura réaliser d'autres circuits, propres à détecter une surtension de polarité donnée et à réaliser une commutation de connexion en réponse à cette détection. L'homme de l'art saura choisir d'utiliser l'invention soit en renforcement des solutions de l'art antérieur, soit, si la surface occupée par les inverseurs est suffisamment importante, comme unique moyen d'évacuation des surtensions entre les rails d'alimentation. Par exemple, l'homme de l'art saura dans ce dernier cas se passer du transistor MOS de la structure de protection traditionnelle décrite ci-dessus en relation avec la figure 2. Par ailleurs, on a mentionné dans la description d'un mode de réalisation de l'invention des tensions positives et des tensions négatives, il est bien sur entendu que le terme "positif" désigne des tensions supérieures aux tensions désignées par le terme "négatif" et inversement. L'homme de l'art saura mettre en oeuvre le fonctionnement recherché quelles que soient les valeurs de tensions considérées.

## Revendications

1. Circuit intégré protégé contre des décharges électrostatiques comportant :
- des premier et second rails d'alimentation (5, 7) ;
- des premier et second rails intermédiaires (5', 7') normalement connectés aux premier et second rails d'alimentation ;
- des inverseurs, existants pour le fonctionnement normal du circuit intégré, constitués d'un transistor MOS à canal P (31) relié en série à un transistor MOS à canal N (33), les sources (45, 55) des transistors MOS à canal P et N étant respectivement reliées aux premier et second rails d'alimentation et les corps (49, 59) des transistors MOS à canal P et N étant respectivement reliés aux premier et second rails intermédiaires ;
- un détecteur de surtension positive entre les premier et second rails d'alimentation ; et
- un commutateur pour relier les premier et second rails intermédiaires (5', 7') aux second et premier rails d'alimentation (7, 5) lorsque une surtension positive est détectée.

2. Circuit intégré selon la revendication 1, dans lequel l'ensemble du détecteur de surtension positive et du commutateur comprend :
- une résistance (81) et un condensateur (83) ayant un noeud de connexion commun, reliés en série entre les rails d'alimentation (5, 7) ;
- un premier inverseur (85) en série avec un second inverseur (87), l'entrée du premier inverseur (85) étant connectée audit noeud de connexion, le premier rail intermédiaire (5') étant connecté à la sortie du second inverseur (87) et le second rail intermédiaire (7') étant connecté à la sortie du premier inverseur (85) ;
- une première diode (89) connectée en direct entre le premier rail intermédiaire (5') et le premier rail d'alimentation (5) ; et
- une seconde diode (91) connectée en inverse entre le second rail intermédiaire (7') et le second rail d'alimentation (7).

3. Circuit intégré selon la revendication 2, dans lequel les première et seconde diodes (89, 91) sont constituées des diodes parasites présentes dans les premier et second inverseurs (85, 87).

4. Circuit intégré selon l'une quelconque des revendications 1 à 3, dans lequel 50 à 95% de la surface totale sont occupés par les inverseurs.

5. Procédé de protection contre des surtensions d'un circuit intégré comportant des premier et second rails d'alimentation (5, 7), des premier et second rails intermédiaires (5', 7'), et des inverseurs constitués d'un transistor MOS à canal P (31) relié en série à un transistor MOS à canal N (33), les sources (45, 55) des transistors MOS à canal P et N étant respectivement reliées aux premier et second rails d'alimentation (5, 7) et les corps (49, 59) des transistors MOS à canal P et N étant respectivement reliés aux premier et second rails intermédiaires (5', 7'), ce procédé comportant les étapes suivante :
- détecter des surtensions éventuelles entre les premier (5) et second (7) rails d'alimentation lorsque le circuit intégré n'est pas alimenté,
- connecter le premier rail intermédiaire (5') au premier rail d'alimentation (5) et le second rail intermédiaire (7') au second rail d'alimentation (7) lorsque le circuit intégré est alimenté ou lorsque le circuit intégré n'est pas alimenté et qu'une surtension négative est détectée, et
- connecter le premier rail intermédiaire (5') au second rail d'alimentation (7) et le second rail intermédiaire (7') au premier rail d'alimentation (5) lorsque le circuit n'est pas alimenté et qu'une surtension positive est détectée.

## Revendications modifiées

### Revendications modifiées conformément à la règle 137(2) CBE.

**1.** Circuit intégré protégé contre des décharges électrostatiques comportant :
- des premier et second rails d'alimentation (5, 7) ;
- des premier et second rails intermédiaires (5', 7') normalement connectés aux premier et second rails d'alimentation ;
- des inverseurs, existants pour le fonctionnement normal du circuit intégré, constitués d'un transistor MOS à canal P (31) relié en série à un transistor MOS à canal N (33), les sources (45, 55) des transistors MOS à canal P et N étant respectivement reliées aux premier et second rails d'alimentation et les corps (49, 59) des transistors MOS à canal P et N étant respectivement reliés aux premier et second rails intermédiaires ;
- un détecteur de surtension positive entre les premier et second rails d'alimentation ; et
- un commutateur pour relier les premier et second rails intermédiaires (5', 7') aux second et premier rails d'alimentation (7, 5) lorsque une surtension positive est détectée.

**2.** Circuit intégré selon la revendication 1, dans lequel l'ensemble du détecteur de surtension positive et du commutateur comprend :
- une résistance (81) et un condensateur (83) ayant un noeud de connexion commun, reliés en série entre les rails d'alimentation (5, 7) ;
- un premier inverseur (85) en série avec un second inverseur (87), l'entrée du premier inverseur (85) étant connectée audit noeud de connexion, le premier rail intermédiaire (5') étant connecté à la sortie du second inverseur (87) et le second rail intermédiaire (7') étant connecté à la sortie du premier inverseur (85) ;
- une première diode (89) connectée en direct entre le premier rail intermédiaire (5') et le premier rail d'alimentation (5) ; et
- une seconde diode (91) connectée en inverse entre le second rail intermédiaire (7') et le second rail d'alimentation (7).

**3.** Circuit intégré selon la revendication 2, dans lequel les première et seconde diodes (89, 91) sont constituées des diodes parasites présentes dans les premier et second inverseurs (85, 87).

**4.** Circuit intégré selon l'une quelconque des revendications 1 à 3, dans lequel 50 à 95% de la surface totale sont occupés par les inverseurs.

**5.** Procédé de protection contre des surtensions d'un circuit intégré comportant des premier et second rails d'alimentation (5, 7), des premier et second rails intermédiaires (5', 7'), et des inverseurs, existants pour le fonctionnement normal du circuit intégré, constitués d'un transistor MOS à canal P (31) relié en série à un transistor MOS à canal N (33), les sources (45, 55) des transistors MOS à canal P et N étant respectivement reliées aux premier et second rails d'alimentation (5, 7) et les corps (49, 59) des transistors MOS à canal P et N étant respectivement reliés aux premier et second rails intermédiaires (5', 7'), ce procédé comportant les étapes suivantes :
- détecter des surtensions éventuelles entre les premier (5) et second (7) rails d'alimentation lorsque le circuit intégré n'est pas alimenté,
- connecter le premier rail intermédiaire (5') au premier rail d'alimentation (5) et le second rail intermédiaire (7') au second rail d'alimentation (7) lorsque le circuit intégré est alimenté ou lorsque le circuit intégré n'est pas alimenté et qu'une surtension négative est détectée, et
- connecter le premier rail intermédiaire (5') au second rail d'alimentation (7) et le second rail intermédiaire (7') au premier rail d'alimentation (5) lorsque le circuit n'est pas alimenté et qu'une surtension positive est détectée.
